# FASCICULE DE BREVET EUROPEEN

(11) **EP 3 037 829 B1**
(45) Date de publication et mention de la délivrance du brevet: **04.04.2018**
(21) Numéro de dépôt: 15201915.4
(22) Date de dépôt: 22.12.2015
(51) Int. Cl.: G01R 15/18, H01F 38/30, G01R 1/04, H01F 27/02, B23K 26/21

(54) **CAPTEUR DE COURANT ET PROCÉDÉ DE FABRICATION D'UN TEL CAPTEUR**
STROMSENSOR UND HERSTELLUNGSVERFAHREN EINES SOLCHEN SENSORS
CURRENT SENSOR AND METHOD FOR MANUFACTURING SUCH A SENSOR

(30) Priorité: 23.12.2014 FR 1463219
(43) Date de publication de la demande: 29.06.2016
(73) Titulaire: Schneider Electric Industries SAS, 92500 Rueil-Malmaison (FR)
(72) Inventeur: OLIVIER, Audrey, 38050 GRENOBLE Cedex 09 (FR); LOGLISCI, David, 38050 GRENOBLE Cedex 09 (FR); RAPEAUX, Michel, 38050 GRENOBLE Cedex 09 (FR)
(74) Mandataire: Lavoix

(56) Documents cités:
- EP-A1- 2 667 205
- JP-A- S57 184 398
- US-A1- 2009 039 880
- US-A1- 2012 140 391

## Description

L'invention est relative à un capteur de courant comprenant des éléments de mesure de courant et à un procédé de fabrication d'un tel capteur.

L'invention concerne notamment les capteurs de courant mixtes comprenant dans un boitier un capteur magnétique de courant ayant un bobinage enroulé autour d'un circuit magnétique et un dispositif de mesure de courant comportant un bobinage de type Rogowski.

Les dispositifs de mesure de courant de type Rogoswki, tel que le capteur de courant du document EP-A-2 667 205, comprennent un support en matériau amagnétique placé autour d'un conducteur ou ligne de courant dans lequel circule le courant à mesurer. Un fil conducteur est bobiné sur le support pour former un enroulement secondaire. L'ensemble forme un transformateur où le conducteur ou ligne de courant constitue un enroulement primaire et l'enroulement secondaire fournit un signal de mesure. La tension fournie aux bornes de l'enroulement secondaire est directement proportionnelle à l'intensité du courant électrique circulant dans le conducteur ou ligne de courant. L'absence de noyau magnétique risquant d'être saturé, permet une large dynamique de mesure.

Le boitier du capteur de courant est en deux parties, avec un socle creux refermé par un couvercle assemblé au socle par exemple par soudage. L'isolation du capteur de courant est simplement assurée par l'électronique du capteur. L'isolation diélectrique se situe entre les lignes de courant et le boîtier du capteur. En cas de défaut au niveau de la soudure des parties du boîtier, l'utilisateur est en danger.

Pour permettre notamment l'ajout d'une prise, par exemple de type USB standard, il est nécessaire d'améliorer l'isolation réalisée par le boitier du capteur de courant car la prise USB génère des fuites de courant. Par exemple, le capteur de courant est intégré dans un disjoncteur présentant une face avant équipée d'une interface programmable dotée d'une prise USB. Le capteur de courant est relié à la face avant pas des fils électriques. Il est nécessaire d'isoler l'utilisateur de la tension présente dans le disjoncteur et au travers du capteur.

L'invention vise à proposer un capteur de courant ayant une isolation diélectrique améliorée à une température de fonctionnement élevée, au-dessus de 140° C

A cet effet, l'invention a pour objet un capteur de courant comprenant des éléments de mesure de courant logés dans un boitier, le boitier comprenant une première partie et une deuxième partie en matière plastique, soudées l'une à l'autre, qui délimitent ensemble un logement de réception des éléments de mesure. La première partie est opaque pour absorber un faisceau laser de soudage des parties du boitier. La deuxième partie est transparente pour laisser passer le faisceau laser.

Grâce à l'invention, les matériaux employés pour le boitier du capteur autorisent un soudage laser de la première partie du boîtier sur la deuxième partie, ce qui améliore l'isolation électrique réalisée par le boîtier. Il est ainsi inutile de prévoir que l'électronique à l'intérieur du boîtier assure une fonction de double isolation, qui est coûteuse, complexe, et augmente l'encombrement.

Selon des aspects avantageux de l'invention, un tel capteur peut incorporer une ou plusieurs des caractéristiques suivantes, prises dans toute combinaison techniquement admissible :
- La première partie absorbe au moins 60 %, de préférence au moins 90 %, de la puissance d'un faisceau laser ayant une longueur d'onde comprise entre 625 et 1100 nm, le matériau de la première partie étant notamment de couleur noire.
- La deuxième partie laisse passer au moins 30 %, de la puissance d'un faisceau laser ayant une longueur d'onde comprise entre 625 et 1100 nm.
- La première partie délimite le logement et la deuxième partie est plane.
- De préférence, l'épaisseur de la deuxième partie est comprise entre 0.5 et 3 mm, de préférence comprise entre 0.8 et 1.6 mm.
- Les parties du boitier sont fabriquées à partir d'une composition polymérique avec un retardateur de flamme organophosphoré.
- Les bords d'au moins l'une des parties du boitier sont pourvus de languettes, de préférence sécables.

Un autre aspect de l'invention concerne un procédé de fabrication d'un capteur de courant comprenant des éléments de mesure de courant logés dans un boitier comprenant une première partie et une deuxième partie qui délimitent ensemble un logement de réception des éléments de mesure, le procédé comprenant une étape de montage dans laquelle les éléments de mesure sont montés dans le boitier. Le procédé comprend une étape d'assemblage dans laquelle les parties du boitier sont assemblées entre elles par un procédé de soudure laser.

Selon des aspects avantageux de l'invention, un tel procédé peut incorporer une ou plusieurs des caractéristiques suivantes, prises dans toute combinaison techniquement admissible :
- Le procédé comprend une étape intermédiaire entre l'étape de montage et l'étape d'assemblage, dans laquelle le logement est mis en dépression, par exemple une dépression supérieure à 60 kPa, de préférence supérieure à 90 kPa.
- De préférence, les bords d'au moins l'une des parties du boitier sont pourvus de languettes d'appui. Lors de l'étape intermédiaire, un appui sur les languettes renforce le contact mécanique entre les parties du boitier.

L'invention sera mieux comprise à la lecture de la description qui va suivre d'un dispositif conforme à l'invention, et de son procédé de fabrication, donnée uniquement à titre d'exemple et faite en référence aux dessins annexés dans lesquels :
- la figure 1 est une vue en perspective éclatée d'un capteur de courant conforme à l'invention ;
- la figure 2 est une vue en perspective du capteur de courant en configuration assemblée ;
- les figures 3 et 4 sont des vues en perspective d'un socle d'un boitier du capteur de courant des figures 1 et 2, selon les flèches F3 et F4 à la figure 1.

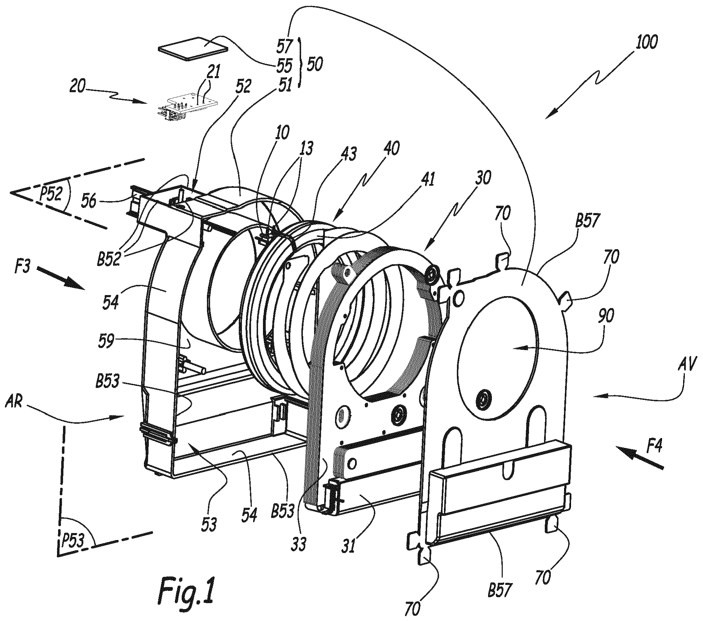

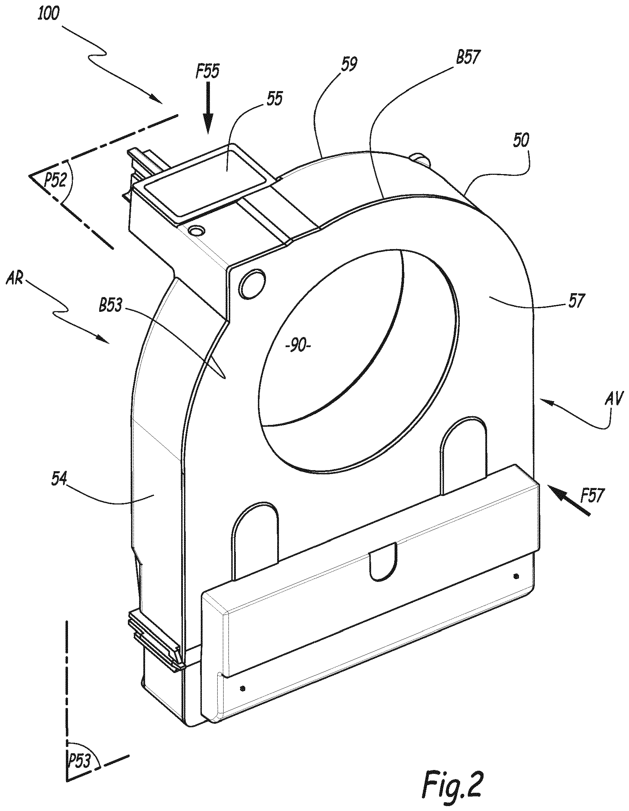

Le capteur de courant 100 représenté aux figures 1 et 2 comprend un capteur magnétique de courant électrique 30 et un dispositif de mesure de courant électrique 40 assemblés dans un boitier 50. Il s'agit d'un capteur de courant mixte.

Le capteur magnétique 30 comporte un premier bobinage 31 enroulé autour d'un circuit magnétique 33.

Le dispositif de mesure 40 comporte un deuxième bobinage 41 de type Rogowski disposé de manière à ce qu'un premier circuit primaire du capteur magnétique 30 corresponde à un deuxième circuit primaire du dispositif de mesure de courant 40. Le bobinage 41 de type Rogowski est composé une carcasse isolante 43 sur laquelle est bobiné un fil métallique. A titre d'exemple de réalisation, la carcasse 43 est de forme circulaire, creuse, en matériau amagnétique, rigide ou semi-rigide et de préférence de section cylindrique ou ovoïde. Le fil métallique enroulé sur la carcasse 43 est de préférence en cuivre ou en un alliage à base de cuivre.

Le boitier 50 est muni d'un évidemment central 90 permettant le passage du conducteur ou ligne de courant sur lequel est effectuée la mesure du courant. Ce conducteur ou ligne de courant forme le circuit primaire du dispositif de mesure de courant 40.

Le capteur de courant 100 comprend des moyens électroniques 20 d'acquisition et de mesure du courant électrique. Les moyens électroniques 20 sont alimentés par le bobinage 31 du capteur magnétique 30.

Une cassette de liaison 10 comprenant des moyens de fixation relie le dispositif de mesure 40 aux moyens électroniques 20.

Le boitier 50 comporte une première partie ou socle 51, comprenant un logement 52 pour les moyens électroniques 20 d'acquisition et de mesure. L'une des parois 56 du logement 52 comporte une ouverture 58 pour le passage de la cassette de liaison 10.

Les moyens de fixation sont agencés pour positionner et maintenir par encliquetage la cassette 10 sur dispositif de mesure de courant 40. La cassette 10 est fixée sur le dispositif de mesure 40 dans une position reproductible, ce qui facilite le montage du capteur de courant 100.

La carcasse 43 du bobinage 41 comporte des moyens d'encliquetage aptes à collaborer avec les moyens de fixation de la cassette de liaison 10.

Des seconds moyens de fixation de la cassette 10 sont agencés pour positionner et maintenir par encliquetage la cassette 10 et le dispositif de mesure 40 sur le boitier 50. L'ensemble formé par la cassette de liaison 10 et le dispositif de mesure 40 est fixé au boitier 50 dans une position reproductible, ce qui facilite le montage du capteur de courant 100.

La cassette 10 comporte des broches électriques 13 reliées respectivement au bobinage 41 et aux moyens électroniques 20. A titre d'exemple, les broches électriques 13 sont soudées aux moyens électroniques 20. Un procédé automatisé de soudure par brasure étain laser peut être utilisé. De manière optionnelle, les moyens électroniques 20 comportent des plots de connexion destinés à être reliés à une prise.

Le socle 51 délimite un premier logement 53 creux à l'intérieur duquel sont positionnés le capteur magnétique 30 et le dispositif de mesure 40. Le socle 51 comprend une paroi de fond 59 globalement plane qui définit une face arrière AR du capteur de courant 100 et communique avec le second logement 52 par l'ouverture 58. La paroi de fond 59 est attenante à des parois latérales 54 du socle s'étendant perpendiculairement à la paroi de fond 59. Des bords externes B53 de ces parois 54 s'étendent dans un premier plan P53. Le logement 53 est un volume creux ouvert vers l'extérieur du boitier 50, à l'opposé de la paroi de fond 59.

La paroi de fond 59 a globalement la forme d'un rectangle dont un bord de petite longueur est en forme de demi-cercle.

Le boitier 50 comprend une deuxième partie ou premier couvercle 57 plan fixé sur les bords externes B53 des parois 54 du logement 53 du socle 51, qui referme le logement 53 et définit la face avant AV du boitier 50. Le couvercle 57 est parallèle à la paroi de fond 59 et sa forme est analogue à celle de la paroi de fond 59. On note B57 les bords externes du couvercle 57, qui sont soudés aux bords B53 des parois 54

Le capteur magnétique 30 est connecté aux moyens électroniques 20 par des pistes électriques. Les moyens électroniques 20 comportent une plaque de circuit imprimé agencée pour être positionnée à l'intérieur des parois 56 du second logement 52. La plaque du circuit imprimé comporte des trous 21 autorisant le passage par emboitement des broches électriques 13 de la cassette 10.

De manière facultative, le boitier 50 comprend un deuxième couvercle 55 plan destiné à être fixé sur des bords externes B52 des parois 56 du second logement 52 du socle 51. Les bords B52 s'étendent dans un deuxième plan P52 perpendiculaire au premier plan B53. Les bords B52 délimitent une ouverture du logement 52 qui débouche à l'extérieur du boitier 50.

Le socle 51 et les couvercles 55 et 57 délimitent ensemble le volume creux du boitier 50, c'est-à-dire le logement 53.

Le socle 51 et les couvercles 55 et 57 sont fabriqués à partir d'un matériau plastique, par exemple un polymère, adapté pour permettre l'assemblage des couvercles 55 et 57 avec le socle 51 par un procédé de soudure laser. La longueur d'onde du faisceau laser utilisé pour cet assemblage, représenté par les flèches F55 et F57 à la figure 2, est comprise dans le domaine et de l'infrarouge, à savoir entre 625 et 1100 nm. A titre d'exemple, la longueur d'onde du faisceau laser F55 ou F57 est égale à 980 nm. Par exemple, la puissance du faisceau laser F55 ou F57 est égale à 480 W.

Pour la soudure du premier couvercle 57, le faisceau laser F57 est orienté perpendiculairement au plan du couvercle 57 et aux bords B53, parallèlement aux parois 54 du socle 51. Le faisceau laser F57 est positionné à l'extérieur du boitier 50, dans le prolongement des parois 54 du logement 53 et il est orienté en direction du couvercle 57.

Pour la soudure du deuxième couvercle 55, le faisceau laser F55 est orienté perpendiculairement au plan du couvercle 55, parallèlement aux parois 56 et aux bords B52, et dans leur prolongement. Le faisceau laser F55 est positionné à l'extérieur du boitier 50, dans le prolongement des parois 56 du logement 52 et il est orienté en direction du couvercle 55.

Le faisceau laser F55 ou F57 fait fondre la matière du boitier 50, ce qui soude le couvercle 55 ou 57 aux bords B52 ou B53 du socle 51. Ainsi, on obtient une continuité de matière entre le socle 51 et le couvercle 55 ou 57 et les espaces libres entre ces éléments sont supprimés, ce qui améliore l'isolation électrique du boitier 50. On réalise ainsi une étanchéité diélectrique entre le socle 51 et le couvercle 55 ou 57.

Le matériau des couvercles 55 et 57 est choisi pour que, lors de la soudure, le faisceau laser F55 ou F57 traverse la matière du couvercle 55 ou 57 et qu'il soit absorbé par la matière du boîtier 51. Les couvercles 55 et 57 sont transparents pour laisser passer le faisceau F55 ou F57, au moins de manière partielle, tandis que le socle 51 est opaque pour absorber le faisceau F55 ou F57, au moins de manière partielle.

Les couvercles 55 et 57 laissent passer le faisceau laser F55 ou F57 de manière plus importante que le socle 51. De même, le socle 51 absorbe le faisceau laser F55 ou F57 de manière plus importante que les couvercles 55 et 57.

Par « transparents », on entend que les couvercles 55 et 57 laissent passer au moins 60 % de l'intensité totale du faisceau F55 ou F57, de préférence au moins 90 %. La valeur de la transparence des couvercles 55 et 57 dépend de leur épaisseur respective. De préférence, l'épaisseur des couvercles 55 et 57 est comprise entre 0.5 et 3 mm, de préférence entre 0.8 et 1.6 mm. Par exemple, les couvercles 55 et 57 ont une épaisseur constante de 1.2 mm.

Par « opaque », on entend que le socle absorbe au moins 30 % de l'intensité totale du faisceau F55 ou F57.

Par exemple, les couvercles 55 et 57 et le socle 51 sont fabriqués à partir d'un matériau plastique ignifugé, réalisé à partir d'une composition polymérique avec un retardateur de flamme. Par exemple, la composition polymérique est une résine de type polyamide partiellement aromatique renforcé avec des fibres de verre à hauteur de 20 à 40 % et ignifugé, de préférence avec un système ignifugeant organophosphoré. On choisira de préférence la teinte de couleur « naturelle », pour les couvercles 55 et 57 D'autres couleurs claires peuvent convenir. Et on choisira de préférence la teinte de couleur « noire » pour le socle 51, mais d'autres couleurs absorbantes peuvent convenir. La couleur noire est obtenue par exemple par l'ajout de pigments noirs qui favorisent l'absorption du faisceau laser F1 ou F2. Il peut s'agir d'un pigment minéral de type noir de carbone, ou d'un pigment organique de type négrosine.

Ces matériaux respectent la norme CEI 60947-1 relative à l'isolation électrique. Comme indiqué dans le tableau XV de cette norme, pour une tension assignée d'isolement Ui de 1000 V, la longueur minimale des lignes de fuites Lf, pour un degré de pollution 3 et le groupe I de matériaux, est égale à 12.5 mm. Pour une tension assignée d'isolement Ui de 1250 V, la longueur minimale des lignes de fuites Lf est égale à 16 mm. Pour une isolation renforcée, ces longueurs sont multipliées par deux. Les groupes de matériaux sont définis par leur indice de résistance au cheminement, qui est supérieur ou égal à 600 V pour le groupe I.

Le degré de pollution est défini par la norme CEI 60664-1 :1992 et caractérise la pollution prévue du micro-environnement. Le degré de pollution 3 indique la présence d'une pollution conductrice ou d'une pollution sèche, non conductrice, qui devient conductrice par la suite de la condensation qui peut se produire.

Conformément à la norme CEI 61140, au paragraphe 5.1, les peintures, vernis, laques et produits analogues ne sont pas considérés comme constituant une isolation suffisante pour la protection contre les chocs électriques en fonctionnement normal.

En variante, le socle 51 et le premier couvercle 57 du boitier 50 sont remplacés par deux demi-boitiers qui ont chacun une forme en creux et qui comportent chacun des bords externes s'étendant dans un plan et destinés à être fixés les uns avec les autres. Ces deux parties du boitier définissent alors un volume de réception du capteur magnétique et du dispositif de mesure 40, lorsqu'ils sont en configuration assemblée, c'est-à-dire lorsque leurs bords externes sont fixés les uns avec les autres.

L'invention a été décrite en référence à un capteur de courant mixte incluant bobinage de type Rogowski, mais elle s'applique également à d'autres types de capteurs de courant. Dans l'exemple décrit, les éléments 10, 20, 30 et 40 forment des moyens de mesure du courant, mais ces éléments peuvent être remplacés par d'autres types de moyens de mesure de courant.

En variante, l'invention s'applique à tout système qui comprend des éléments de mesure de courant, par exemple un capteur, un inducteur, des capteurs à effet Hall ou des capteurs à magnétorésistances, voire des éléments électromécaniques, par exemple un actionneur tel qu'un organe de commande, notamment un disjoncteur.

L'invention est aussi relative à un procédé de fabrication d'un système comprenant des éléments de mesure de courant électroniques ou électromagnétiques. Il peut s'agir d'un capteur de courant tel que le capteur de courant 100 décrit ci-dessus.

Le procédé consiste, dans une première étape, à monter la cassette 10, les moyens électroniques 20, le capteur magnétique 30 et le dispositif de mesure 40 dans le logement 53 du socle 51 du boitier 50.

La cassette 10 est fixée sur la carcasse 43 du dispositif de mesure 40. Les fils du bobinage 41 de type Rogowski sont reliés électriquement aux broches électriques 13 de la cassette 10.

L'ensemble formé par la cassette 10 et la carcasse 43 est alors positionné et fixé dans le logement 53 du socle 51 du boiter 50.

Le capteur magnétique 30 est ensuite fixé dans le socle 51 du boitier 50. Des moyens de fixation permettent de solidariser le capteur magnétique 30 et le dispositif de mesure 40 au socle 51 du boitier 50. Une liaison électrique est réalisée entre les pistes électriques et le bobinage 31 du capteur magnétique 30. La liaison peut être assurée par exemple par soudure électrique.

La plaque de circuit imprimé des moyens électroniques 20 est ensuite positionnée à l'intérieur des parois du premier logement 52. Les broches électriques 13 de la cassette 10 de liaison traversent les trous 21 présents sur le circuit. Les broches électriques 13 sont alors soudées de préférence par un procédé automatisé de soudure par brasure étain laser.

Dans une étape subséquente, les couvercles 55 et 57 sont assemblés au socle 51. L'ordre d'assemblage des couvercles 55 et 57 sur le socle est indifférent.

Le premier couvercle 57 est positionné sur les bords externes B53 des parois 54 du premier logement 53 du socle 51. Le premier couvercle 57 et les bords B53 s'étendent dans le plan P53, assurant un contact mécanique entre les bords B53 et le couvercle 57. Le premier couvercle 57 est alors soudé sur les bords B53 au moyen du faisceau laser F57.

Pour améliorer le contact mécanique lors du soudage laser entre le socle 51 et le premier couvercle 57, un système d'aspiration est utilisé pour faire le vide à l'intérieur du boitier 50, avant le soudage du couvercle 55. Par exemple, le vide est créé par l'ouverture 58 du socle 51. Un vacuostat vérifie la pression à l'intérieur du boitier 50. Lors du passage du faisceau laser F57, on constate une diminution de 0.3 mm de l'épaisseur du couvercle 57. La dépression permet d'assurer un contact mécanique entre le couvercle 57 et le socle 51 malgré cette déformation. Par exemple, la dépression est supérieure à 60 kPa, de préférence supérieur à 80 kPa.

Afin d'améliorer le contact mécanique entre le couvercle 57 et le boitier 51, le couvercle 57 est pourvu de languettes 70 réparties le long des bords B57 du couvercle 57. Lors du soudage du couvercle 57, lorsque le boitier 50 est mis en dépression, des doigts d'un robot non représenté appuient sur ces languettes 70 pour favoriser le contact avec le socle 51. De préférence, les languettes 70 sont sécables pour faciliter leur arrachement ultérieur.

Le deuxième couvercle 55 est positionné sur les bords externes B52 des parois 56 du deuxième logement 52. Les bords externes B52 et le deuxième couvercle 55 s'étendent dans le plan P52, ce qui assure un contact mécanique entre les bords B52 et le couvercle 55. Le deuxième couvercle 55 est alors soudé sur les bords B52 au moyen du faisceau laser F55.

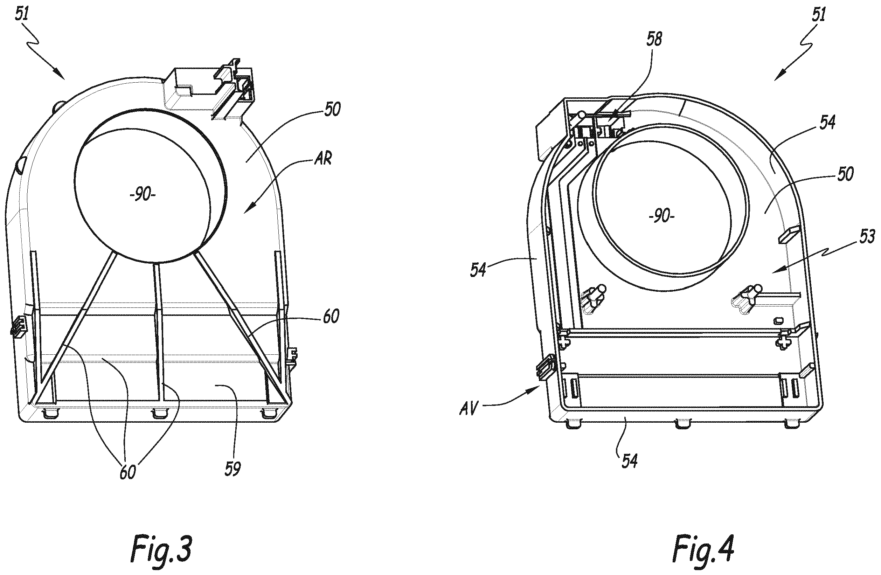

Comme visible à la figure 3, la paroi de fond 59 du socle 51 est pourvue de nervures de renfort 60, sur sa face extérieure, qui participent à la conformité géométrique du socle 51 lors du moulage de cette pièce.

Dans l'exemple décrit, le socle 51 délimite le logement 53 et le couvercle 57 est plan. En variante, les deux parties 51 et 57 du boitier 50 peuvent délimiter chacune un logement, c'est-à-dire présenter une forme concave. Le volume creux du boitier 50 est alors formé par la réunion de ces deux logements.

La présence de plusieurs couvercles 55 et 57 est optionnelle, le boitier 50 peut comporter un seul couvercle.

Conformément à l'invention, les différentes variantes décrites peuvent être combinées entre elles, au moins de manière partielle.

## Revendications

1. Capteur de courant (100) comprenant des éléments de mesure (10, 20, 30, 40) de courant logés dans un boitier (50), le boitier (50) comprenant une première partie (51) et une deuxième partie (55, 57) en matière plastique, soudées l'une à l'autre, qui délimitent ensemble un logement (52, 53) de réception des éléments de mesure, **caractérisé en ce que** la première partie (51) est opaque pour absorber un faisceau laser (F55, F57) de soudage des parties (51, 55, 57) et **en ce que** la deuxième partie (57) est transparente pour laisser passer le faisceau laser (F55 , F57).

2. Capteur de courant (100) selon la revendication 1, **caractérisé en ce que** la première partie (51) absorbe au moins 60 %, de préférence au moins 90 %, de la puissance d'un faisceau laser (F55, F57) ayant une longueur d'onde comprise entre 625 et 1100 nm, le matériau de la première partie (51) étant notamment de couleur noire.

3. Capteur de courant (100) selon l'une des revendications 1 ou 2, **caractérisé en ce que** la deuxième partie (55, 57) laisse passer au moins 30 %, de la puissance d'un faisceau laser (F55, F57) ayant une longueur d'onde comprise entre 625 et 1100 nm.

4. Capteur de courant (100) selon l'une des revendications 1 à 3, **caractérisé en ce que** la première partie (51) délimite le logement (52, 53) et **en ce que** la deuxième partie (55, 57) est plane.

5. Capteur de courant (100) selon la revendication 4, **caractérisé en ce que** l'épaisseur de la deuxième partie (55, 57) est comprise entre 0.5 et 3 mm, de préférence comprise entre 0.8 et 1.6 mm.

6. Capteur de courant (100) selon l'une des revendications précédentes, **caractérisé en ce que** les parties (51, 55, 57) du boitier (50) sont fabriquées à partir d'une composition polymérique avec un retardateur de flamme organophosphoré.

7. Capteur de courant (100) selon l'une des revendications précédentes, **caractérisé en ce que** les bords (B52, B53, B57) d'au moins l'une des parties (51, 55, 57) du boitier (50) sont pourvus de languettes (70), de préférence sécables.

8. Procédé de fabrication d'un capteur de courant (100) comprenant des éléments de mesure de courant (10, 20, 30, 40) logés dans un boitier (50) comprenant une première partie (51) et une deuxième partie (55, 57) qui délimitent ensemble un logement (53) de réception des éléments de mesure, la première partie (51) étant opaque pour absorber un faisceau laser (F55, F57) de soudage des parties (51, 55, 57) et la deuxième partie (57) étant transparente pour laisser passer le faisceau laser (F55 , F57), le procédé comprenant une étape de montage dans laquelle les éléments de mesure (10, 20, 30, 40) sont montés dans le boitier (50), et une étape d'assemblage dans laquelle les parties (51, 55, 57) du boitier (50) sont assemblées entre elles par un procédé de soudure laser.

9. Procédé selon la revendication 8, **caractérisé en ce qu'**il comprend une étape intermédiaire entre l'étape de montage et l'étape d'assemblage, dans laquelle le logement (52, 53) est mis en dépression, par exemple une dépression supérieure à 60 kPa, de préférence supérieure à 80 kPa.

10. Procédé selon la revendication 9, **caractérisé en ce que** les bords (B52, B53, B57) d'au moins l'une des parties (51, 55, 57) du boitier (50) sont pourvus de languettes d'appui (70) et **en ce que**, lors de l'étape intermédiaire, un appui sur les languettes (70) renforce le contact mécanique entre les parties (51, 55, 57) du boitier (50).

## Patentansprüche

1. Stromsensor (100), aufweisend Strom-Messelemente (10, 20, 30, 40), die in einem Gehäuse (50) untergebracht sind, wobei das Gehäuse (50) aufweist einen ersten Teil (51) und einen zweiten Teil (55, 57) aus Kunststoffmaterial, die aneinander geschweißt sind und die zusammen eine Unterbringung (52, 53) zur Aufnahme der Messelemente begrenzen, **dadurch gekennzeichnet, dass** der erste Teil (51) opak ist zum Absorbieren eines Laserstrahls (F55, F57) zum Schweißen der Teile (51, 55, 57) und dass der zweite Teil (57) transparent ist zum Passieren-Lassen des Laserstrahls (F55, F57).

2. Stromsensor (100) gemäß Anspruch 1, **dadurch gekennzeichnet, dass** der erste Teil (51) wenigstens 60%, bevorzugt wenigstens 90% der Leistung eines Laserstrahls (F55, F57) absorbiert, der eine Wellenlänge von zwischen 625 und 1100 nm hat, wobei das Material des ersten Teils (51) insbesondere von schwarzer Farbe ist.

3. Stromsensor (100) gemäß einem der Ansprüche 1 oder 2, **dadurch gekennzeichnet, dass** der zweite Teil (55, 57) wenigstens 30% der Leistung eines Laserstrahls (F55, F57) passieren lässt, der eine Wellenlänge von zwischen 625 und 1100 nm hat.

4. Stromsensor (100) gemäß einem der Ansprüche 1 bis 3, **dadurch gekennzeichnet, dass** der erste Teil (51) die Unterbringung (52, 53) begrenzt und dass der zweite Teil (55, 57) eben ist.

5. Stromsensor (100) gemäß Anspruch 4, **dadurch gekennzeichnet, dass** die Dicke des zweiten Teils (55, 57) zwischen 0,5 und 3 mm, bevorzugt zwischen 0,8 und 1,6 mm, beträgt.

6. Stromsensor (100) gemäß einem der vorhergehenden Ansprüche, **dadurch gekennzeichnet, dass** die Teile (51, 55, 57) des Gehäuses (50) hergestellt sind aus einer polymerischen Zusammensetzung mit einem Organophosphat-Flammen-Hemmer.

7. Stromsensor (100) gemäß einem der vorhergehenden Ansprüche, **dadurch gekennzeichnet, dass** die Ränder (B52, B53, B57) wenigstens eines der Teile (51, 55, 57) des Gehäuses (50) mit Zungen (70) versehen sind, die bevorzugt teilbar sind.

8. Verfahren zur Herstellung eines Stromsensors (100), aufweisend Strom-Messelemente (10, 20, 30, 40), die in einem Gehäuse (50) untergebracht sind, das einen ersten Teil (51) und einen zweiten Teil (55, 57) aufweist, die zusammen eine Unterbringung (53) zur Aufnahme der Messelemente begrenzen, wobei der erste Teil (51) opak ist zum Absorbieren eines Laserstrahls (F55, F57) zum Schweißen der Teile (51, 55, 57) und der zweite Teil (57) transparent ist zum Passieren-Lassen des Laserstrahls (F55, F57), wobei das Verfahren aufweist einen Montageschritt, in welchem die Messelemente (10, 20, 30, 40) in dem Gehäuse (50) montiert werden, und einen Zusammenbauschritt, in welchem die Teile (51, 55, 57) des Gehäuses (50) miteinander zusammengebaut werden durch einen Laserschweißprozess.

9. Verfahren gemäß Anspruch 8, **dadurch gekennzeichnet, dass** es aufweist einen Zwischenschritt zwischen dem Montageschritt und dem Zusammenbauschritt, in welchem die Unterbringung (52, 53) unter Unterdruck gesetzt wird, zum Beispiel einen Unterdruck größer als 60kPa, bevorzugt größer als 80kPa.

10. Verfahren gemäß Anspruch 9, **dadurch gekennzeichnet, dass** die Ränder (B52, B53, B57) wenigstens eines der Teile (51, 55, 57) des Gehäuses (50) mit Auflage-Zungen (70) versehen sind und dass, während des Zwischenschritts, eine Auflage auf die Zungen (70) den mechanischen Kontakt zwischen den Teilen (51, 55, 57) des Gehäuses (50) verstärkt.

## Claims

1. Current sensor (100) comprising current-measuring elements (10, 20, 30, 40) housed in a casing (50), the casing (50) comprising a first part (51) and a second part (55, 57) made of plastics material, welded to one another, which together delimit a housing (52, 53) for receiving the measuring elements, **characterised in that** the first part (51) is opaque for absorbing a laser beam (F55, F57) for welding the parts (51, 55, 57) and **in that** the second part (57) is transparent in order to allow the laser beam (F55, F57) to pass.

2. Current sensor (100) according to claim 1, **characterised in that** the first part (51) absorbs at least 60%, preferably at least 90%, of the power of a laser beam (F55, F57) having a wavelength between 625 and 1100 nm, the material of the first part (51) being especially black in colour.

3. Current sensor (100) according to either claim 1 or claim 2, **characterised in that** the second part (55, 57) allows at least 30% of the power of a laser beam (F55, F57) having a wavelength between 625 and 1100 nm to pass.

4. Current sensor (100) according to any one of claims 1 to 3, **characterised in that** the first part (51) delimits the housing (52, 53) and **in that** the second part (55, 57) is planar.

5. Current sensor (100) according to claim 4, **characterised in that** the thickness of the second part (55, 57) is between 0.5 and 3 mm, preferably between 0.8 and 1.6 mm.

6. Current sensor (100) according to any one of the preceding claims, **characterised in that** the parts (51, 55, 57) of the casing (50) are manufactured from a polymeric composition comprising an organophosphorus flame retardant.

7. Current sensor (100) according to any one of the preceding claims, **characterised in that** the edges (B52, B53, B57) of at least one of the parts (51, 55, 57) of the casing (50) are provided with tabs (70), preferably breakable tabs.

8. Method for manufacturing a current sensor (100) comprising current-measuring elements (10, 20, 30, 40) housed in a casing (50) comprising a first part (51) and a second part (55, 57) which together delimit a housing (53) for receiving the measuring elements, the first part (51) being opaque for absorbing a laser beam (F55, F57) for welding the parts (51, 55, 57) and the second part (57) being transparent in order to allow the laser beam (F55, F57) to pass,
the method comprising a mounting step in which the measuring elements (10, 20, 30, 40) are mounted in the casing (50), and an assembly step in which the parts (51, 55, 57) of the casing (50) are assembled by a laser welding process.

9. Method according to claim 8, **characterised in that** it comprises an intermediate step between the mounting step and the assembly step, in which the housing (52, 53) is depressurised, for example a depression greater than 60 kPa, preferably greater than 80 kPa.

10. Method according to claim 9, **characterised in that** the edges (B52, B53, B57) of at least one of the parts (51, 55, 57) of the casing (50) are provided with push tabs (70) and **in that**, during the intermediate step, pushing on the tabs (70) enhances mechanical contact between the parts (51, 55, 57) of the casing (50).
